# EUROPEAN PATENT APPLICATION

(11) **EP 4 624 062 A1**
(43) Date of publication of application: **01.10.2025**
(21) Application number: 24177272.2
(22) Date of filing: 22.05.2024
(51) Int. Cl.: B07B 13/18

(54) **METHOD AND APPARATUS FOR MONITORING SCREENING DEVICE PROCESS EFFICIENCY**

(30) Priority: 29.03.2024 EP 24167837
(71) Applicant: Sandvik Rock Processing Australia Pty Limited, Sunshine, 3020 VIC (AU)
(72) Inventor: Hitchcock, Louise, Victoria 3020 (AU); Rowe, Jacob, Victoria 3020 (AU); Herd, Jeremy, Victoria 3020 (AU)
(74) Representative: Sandvik

(57) **Abstract**

In one aspect there is provided a method (200) of monitoring a screening device process efficiency of a screening device (118), the method comprising: receiving input data relating to operation of the screening device process (S202); based on the input data, determining output data representing a set of performance metrics of the screening device process (S204); based on the output data, determining a machine performance metric indicative of an efficiency of the screening device process (S208); comparing the machine performance metric with machine performance reference data (S210); initiating an adjustment process for adjusting an operation of the screening device based on the indication of the result (S214A).

## Description

### TECHNICAL FIELD

The present disclosure pertains to the field of vibratory screening devices, in particular to apparatus and methods for monitoring such vibratory screening devices, and more in particular to apparatus and methods for monitoring a screening device process.

### BACKGROUND

Screening is a mission critical process part of mineral processing plants and is commonly used to either clean product or to separate ore material based on particle size. Screening process are resource intensive and employed in vastly different environments around the world. Whilst various solutions have been proposed in an attempt to alleviate its challenges, these known solutions are however commonly faced with the assumption that environmental factors are fixed when designing a screening device. In application however, certain process parameters can and will vary, changing the efficiency of the screen performance. In response to these issues, the applicant has devised solutions which address these drawbacks and which affords constructive contributions to the art.

### SUMMARY

In one aspect there is provided a method of monitoring a screening device process efficiency of a screening device. The method may be computer implemented. The method comprises: receiving input data relating to operation of the screening device process; based on the input data, determining output data indicative of a set of performance metrics of the screening device process; based on the output data, determining a machine performance metric indicative of an efficiency of the screening device process. The method may comprise comparing the machine performance metric with machine performance reference data; providing an indication of a result of the comparison. The method may comprise controlling an adjustment process for adjusting an operation of the screening device based on the indication of the result.

In some embodiments, controlling the adjustment process for adjusting an operation of the screening device comprises initiating the adjustment. In some embodiments, controlling the adjustment process for adjusting an operation of the screening device comprises forgoing (such as not triggering, not initiating, and/or not starting) the adjustment process for adjusting an operation. In some embodiments, controlling the adjustment process for adjusting an operation of the screening device comprises forgoing (such as not triggering, not activating, and/or not starting) the initiation of the adjustment process for adjusting an operation of the screening device.

In some embodiments, controlling the adjustment process for adjusting an operation of the screening device comprises displaying one or more user interface objects representative of one or more of: the indication of the result of the comparison, the machine performance metric, and at least one performance metric of the set of performance metrics.

In some embodiments, controlling the adjustment process for adjusting an operation of the screening device comprises communicating a signal indicative of a control of the adjustment process (such as to a sensor and/or an actuator associated with the screening device).

In some embodiments, controlling the adjustment process for adjusting an operation of the screening device comprises controlling one or more screen control parameters. In some embodiments, the one or more screen control parameters includes one or more of: process water spraying parameter, motor speed of an exciter of the screening device, feed speed of the screening device, particle size and/or shape of a feed material being fed to the screening device, stroke shape of the screening device, and stroke angle of the screening device.

In some embodiments the adjustment process comprises communicating a signal.

In some embodiments determining output data comprises normalizing a respective performance metric of the set of performance metrics.

In some embodiments the method further comprising weighting a respective performance metric of the set of performance metrics.

In some embodiments the method further comprises identifying future input data for the adjusting the operation of the screening device by processing the indication of the result with an electronic processor.

In some embodiments the signal is indicative of the one or more future input data for the adjusting the operation.

In some embodiments the identifying of the future input data for the adjusting the operation by processing the indication of the result comprises providing the indication of the result as input to a machine learning model, wherein the machine learning model is trained to receive the indication of the result as input and to produce as an output, an indication [prediction] of the future input data for the adjusting the operation of the screening device. In some embodiments, the identifying of the future input data for the adjusting the operation by processing the indication of the result comprises receiving an indication of the identification of the future input data for the adjusting the operation of the screening device as the output of the machine learning model.

In some embodiments the machine learning model is trained with training data comprising historical input data and output data of at least one of the screening device process and a similar screening device process or combinations thereof.

In some embodiments the indication of the future input data is displayed on a display.

In some embodiments the method further comprises adjusting the operation of the screening device based on the indication of the result.

In some embodiments the input data is indicative of a set of process parameters obtained by a sensor arrangement couped to the screening device. The process parameters may be respectively indicative of a process data point of the screening device process.

In some embodiments one or more of the set of process parameters is determined based on sensor data obtained by the sensor arrangement.

In some embodiments the sensor arrangement comprises at least one of an optical camera, an RGB camera, an accelerometer, a voltage sensor, a current sensor, a lidar sensor, optical sensor, a depth sensor and a power sensor.

In some embodiments the input data is indicative of a set of process characteristics respectively indicative of one of a physical property of the screening device and a material being processed or to be processed by the screening device process.

In some embodiments the input data relates to a set of adjustable screen control parameters of the screening device, such as a respective setting of the set of adjustable screen control parameters.

In some embodiments the adjustment process comprises changing a setting of one or more of the adjustable screen control parameters.

In some embodiments the screening device setting comprises a setting of the adjustable screen control parameters.

In some embodiments the machine performance metric is displayed on a display.

In some embodiments one or more of the set of performance metrics is displayed on a display. Thereby communicating the dynamic internal state of the screening device.

In some embodiments the indication of the result of the comparison is displayed on a display. Thereby communicating the dynamic internal state of the screening device.

In some embodiments the set of screen control parameters includes any of process water spraying, motor speed of an exciter of the screening device, feed speed of the screening device, particle size and/or shape of a feed material being fed to the screening device, stroke shape of the screening device, and stroke angle of the screening device.

In some embodiments the set of process parameters includes parameters indicative of any of particle separation efficiency of the screening device process, particle size distribution of the screening device process, motor speed of an exciter of the screening device, a moisture content of a material in the screening device process, bed depth of a bed of material in the screening device process, stroke length of the screening device, particle shape factor of a material in the screening device process.

In some embodiments the set of process characteristics includes any of screen size of the screening device, screen bed shape of the screening device, a type of material in the screening device process, such as ore type, a screening application, a screen panel configuration of the screening device, a screen exciter type of the screening device.

In some embodiments the set of performance metrics includes any of a throughput of the screening device process, a water consumption of the screening device process, a power consumption of the screening device process, a fines contamination of the screening device process, a coarse contamination of the screening device process.

In a second aspect there is provided an apparatus for a screening device, the apparatus comprising: at least one processor; and at least one memory including computer program code, the at least one memory and the computer program code configured to, with the at least one processor, cause the apparatus at least to perform the method according to any embodiment of the first aspect.

In third aspect there is provided a screening device comprising the apparatus according to the second aspect.

In fourth aspect there is provided a computer program comprising instructions for causing an apparatus to perform the method according to any embodiment of the first aspect.

In a further aspect there is provided a computer-readable [storage] medium comprising instructions which, when executed by a computer, cause the computer to carry out [the operations of] the method according to any embodiment of the first aspect.

In a still further aspect there is provided a screening device monitoring apparatus comprising at least one processor and at least one memory including computer program code, the at least one memory and the computer program code configured to, with the at least one processor, cause the apparatus at least to: perform the method according to any embodiment of the first aspect.

In one aspect there is provided a non-transitory computer readable medium comprising program instructions for causing an apparatus to perform at least the method according to any embodiment of the first aspect.

The provision of such method and apparatus will solve or at least mitigate one or more of the problems or drawbacks identified in the background section of this document, as will be clear from the following detailed description section and the drawings. Hence, some embodiments will enable a user of the screening device to better understand how to operate the screening device. As such, some embodiments may enable the user of the screening device to improve its effectiveness, such as by communicating the dynamic internal state of the screening device. Furthermore, some embodiments may assist the user in performing the technical task of operating the screening device. Additionally, some embodiments may facilitate support to the user in defining what maximum effectiveness is for them, whether that be maximising the throughput of screening material or if it is maximising screening efficiency or some other metric.

### BRIEF DESCRIPTION OF DRAWINGS

Example embodiments will be described in more detail to the following figures, in which:
FIG. 1 is a schematic illustration of the screening device according to some embodiments.
FIG. 2 is a flow diagram of operations of the apparatus according to some embodiments.
FIG. 3 is a block diagram of the apparatus according to some embodiments.

### DETAILED DESCRIPTION

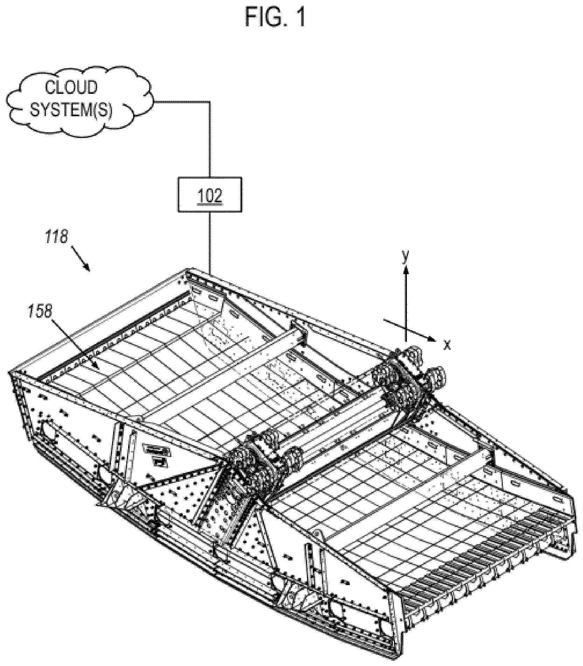

Referring now to FIG. 1, an example screening device 118 with which embodiments can be deployed is shown. Screening device 118 generally comprises at least one screen 158 extending between an inlet end for receiving feed material to be processed, and a discharge end for discharging one or more screened products. The material subject to processing in the screening process is conveyed over the screen 158 through excitation. The material forms on the screen 158 a bed having a bed depth generally extending normal to a screen upper surface. Excitation of the material is realized through at least one exciter comprising a motor. The exciter(s) displaces the screen 158 along a stroke line having respective components in a machine direction x and in a vertical direction y.

The screening device 118 is configured to separate an oversize product, such as a coarse product, from the material flow through the excitation. The separation is facilitated by means of the screen 158 comprising openings (not shown) sized and configured to capture the oversize product while allowing a fines product of particles of the material to fall through the openings under the action of gravity. The screening device 118 may comprise several screens 158, such as stacked on top of each other, for example for separating a second oversize product.

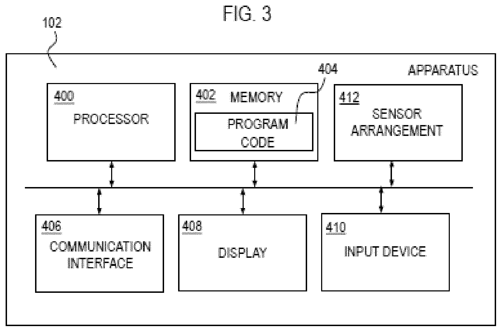

With added reference to FIG. 3, embodiments herein may be performed by an apparatus 102. The apparatus 102 may be comprised in the screening device 118 but may alternatively, or in addition be comprised in any other suitable location such as e.g., in cloud system(s) at a remote location as will be further elucidated herein.

The apparatus 102 comprises a sensor arrangement 412 comprising set of sensors arranged and adapted to monitor operation of the screening device process. The sensor arrangement 412 is configured to monitor a set of process parameters of the screening device process. In some embodiments the apparatus 102 may determine one or more of the set of process parameters, as will be further elucidated herein. As used herein, a "sensor" is a device that measures physical input from its environment and converts it into data that can be interpreted by either a human or a machine. Example sensors are set forth in the below, without limitation.

Examples of the aforementioned set of process parameters may comprise any or all of the process parameters discussed in the below, without limitation.

Particle size distribution (PSD) is a process parameter indicative of a distribution of particles according to their size, such as in a sample. Determining PSD may comprise applying optical granulometry analysis to image data captured by a camera. The sensor arrangement may thus in some embodiments comprise an optical camera, for example an RGB camera.

Feed Rate over screen is a process parameter indicative of a mass flow rate of material over a screen deck of the screening device. Determining feed rate over screen may comprise applying optical particle tracking analysis to image data captured by an optical camera.

Process efficiency is a process parameter indicative of the proportion of fines that are separated from the oversized material. Determining process efficiency may comprise applying optical granulometry analysis to image data captured by a camera to measure the particle size distribution. By measuring and comparing the particle size distribution at both the feed and discharge ends of the screening device the processing efficiency may be determined. In addition, by this process the coarse contamination in the fines may also be determined.

Material Velocity across screen is a process parameter indicative of an average particle velocity over the screen at discharge end 124 and feed end 126. The material velocity may comprise a velocity of the particles as they traverse the screen. Determining material velocity across screen 158 may comprise processing image data captured by an RGB camera by applying particle tracking velocimetry (PTV) analysis.

Moisture Content (MC) is a process parameter indicative of moisture content of the material. Moisture content may comprise a mass proportion of residual water to the dry bulk material. In some embodiments the sensor arrangement determines moisture content by one or more of a capacitive moisture sensor and a NIR (near infrared) moisture sensor.

Live Modal Analysis is a process parameter that may comprise real time modal analysis whilst the screening device is operating and that is indicative of dynamic behaviour of mechanical structures of the screening device 118 as a function of excitation frequency. Live modal analysis may in some embodiments of the sensor arrangement be determined by means of at least one accelerometer.

Particle Shape Factor is a process parameter indicative of the shape of a particle, such as a particle of a material being processed or to be processed in the screening device. Determining particle shape factor may comprise processing image data captured by an RGB camera by to identify shape characteristics of a particle. Typical shape factors identified may include aspect ratio, circularity, convexity, roughness, and solidity.

Feed Bias is a process parameter indicative of lateral mass distribution across the screen deck. Determining Feed Bias may comprise the use of accelerometers, RGB cameras, stereo cameras, structured light sensor, or Time of Flight (ToF) cameras.

Bed Depth is a process parameter indicative of a height profile of material across the face of the screen. Determining bed depth may comprise measuring the bed depth by means of a 3D imaging sensor.

Motor Power is a process parameter indicative of voltage and current draw of the exciter motors. The sensor arrangement may thus in some embodiments comprise a voltage sensor and a current sensor.

Stroke parameters are process parameters indicative of stroke angle, stroke shape and stroke length. The stroke parameters represent the dynamic motion of the screen and may in some embodiments be determined by means of accelerometers.

Moreover, the screening device process may typically be associated with a set of process characteristics. A respective process characteristic may be indicative of one of a physical property of the screening device and a material to be processed, without limitation.

In some embodiments, the set of process characteristics comprises a process characteristic indicative of a screen size of a screening machine. A screen size may comprise a physical size of the screen, such as a screen area or a total screen area of a set of screens in a screening machine.

The set of process characteristics may comprise a characteristic indicative of a screen bed shape. A screen bed shape may comprise a physical shape of the screen.

In some embodiments, the set of process characteristics comprises a characteristic indicative of a material type. Material type may comprise, a type of ore.

The set of process characteristics may comprise a characteristic indicative of a screening application. Screening application may comprise scalping, dewatering and finishing.

In some embodiments, the set of process characteristics comprises a characteristic indicative of a screen panel configuration. Screen panel configuration may comprise of a variety of slotted panel types, with a range of slot shapes, sizes and density, weirs to divert or slow material flow and blanks placed under areas of high material speed.

The set of process characteristics may comprise a characteristic indicative of a screen exciter variables. Screen exciter variables may comprise of number of exciters, location relative to the screen center of gravity and force output of the exciters.

In an example where the disclosed technique is applied, input data indicative of e.g. process water spraying parameter is obtained and used to determine output data indicative of e.g. water consumption. The output data indicative of e.g. water consumption can be used to determine machine performance metric(s) indicative of efficiency of the screening device process, e.g. by taking into account user preferences and/or priorities (such as reducing water consumption and not applying any constraints on power consumption). For example, the determined machine performance metric can be compared to machine performance reference data to provide an indication of a result of the comparison. For example, the indication can be show that water consumption needs to be reduced. For example, the adjustment of the operation of the screening device can be controlled based on the indication. For example, the control operation triggers a reduction of a flow rate of one or more water sprays of the screening device. Optionally, future screen control parameters can be predicted to lead to further reduction of the water consumption by applying the disclosed machine learning model.

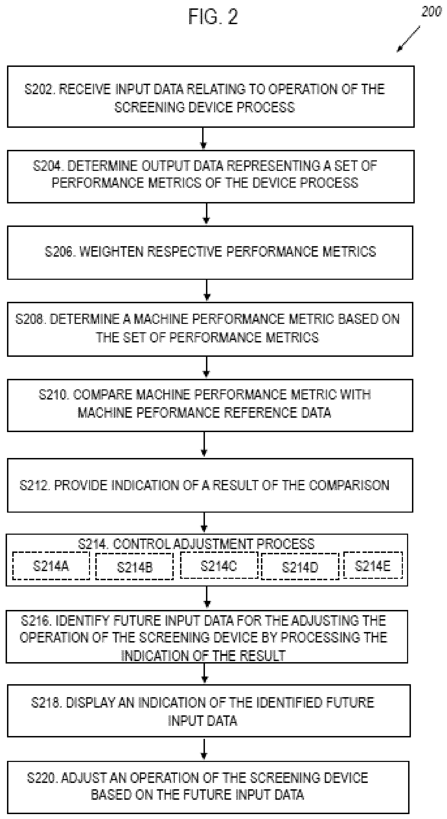

Referring now to FIG. 2, a flow diagram of a method 200 for monitoring a screening device process efficiency is shown. The method may be performed by the apparatus disclosed herein and/or the screening device disclosed herein (such as apparatus 102 of FIG. 1 and/or screening device 118 of FIG.1). The method may be a computer-implemented method.

At S202, input data relating to operation of the screening device process is received. The input data may comprise various types of input data.

In some embodiments, a first type of input data may be indicative of any of the process parameters detailed hereinbefore, such as sensor data.

In some embodiments, a second type of the input data may comprise data relating to a set of process characteristics respectively indicative of one of a physical property of the screening device and a material being processed or to be processed by the screening device process.

In some embodiments, a third type of input data may comprise data relating to a set of adjustable screen control parameters of the screening device, such as respective settings or set-points of the screen control parameters.

At S204, output data indicative of a set of performance metrics of the device process is determined.

In some embodiments, the set of performance metrics comprises a performance metric indicative of throughput of the screening device process. In one or more embodiments, the set of performance metrics comprises a throughput metric. Determining throughput of the screening device process may comprise measuring the volume of material separated from the feed material or the volume of material fed over the screen.

In some embodiments, the set of performance metrics comprises a performance metric indicative of a water consumption of the screening process. In one or more embodiments, the set of performance metrics comprises a water consumption metric. Determining a water consumption may comprise measuring a flow rate of water fed to spray bars arranged to spray water into the screening process.

In some embodiments, the set of performance metrics comprises a performance metric indicative of a power consumption of the screening process. In one or more embodiments, the set of performance metrics comprises a power consumption metric. Determining a power consumption may comprise measuring the power consumed by the exciter motor(s).

In some embodiments, the set of performance metrics comprises a performance metric indicative of a fines contamination of the screening process. In one or more embodiments, the set of performance metrics comprises a fines contamination metric. Determining a fines contamination may comprise measuring the volume of fines not separated from the feed material as a percentage of the available volume of fines in the feed material or the fines not separated from the feed material as a percentage of the volume of course material not separated from the feed material.

In some embodiments, the set of performance metrics comprises a performance metric indicative of a coarse contamination of the screening process. In one or more embodiments, the set of performance metrics comprises a coarse contamination metric. Determining a coarse contamination may comprise measuring the volume of coarse material separated from the feed material as a percentage of the available volume of coarse material in the feed material or the coarse material separated from the feed material as a percentage of the volume of fines separated from the feed material.

In some embodiments, the set of performance metrics comprises a performance metric indicative of one or more of: a throughput, a water consumption, a power consumption, a fines contamination, and a coarse contamination. In some embodiments, the set of performance metrics comprises one or more of: a water consumption metric, a power consumption metric, a fines contamination metric, and a coarse contamination metric.

In some embodiments, respective performance metrics of the set of performance metrics may be normalized. Normalizing a respective performance metric of the set of performance metrics may be based on performance reference data of the set of performance metrics. The performance metric reference data may for example represent a respective classifying efficiency of each of the performance metrics of the set of performance metrics. The performance metric reference data may be received (e.g. retrieved, requested) from a memory 402 of the apparatus 102, or any other memory accessible to the apparatus 102.

By way of example, should the screening process consume 10 liters of water per minute in contrast to a reference efficiency of 5 liters per minute, a normalized performance metric indicative of water consumption may indicate a 50 percent efficiency.

At S206, a respective performance metrics of the set of performance metrics may be weighted. Weighting a respective performance metric may comprise applying a respective weight of a set of weights to a respective performance metric. In some implementations, the set of weights are indicative of one or more of a mutual weight ratio and a mutual prioritization of the set of performance metrics. A respective applied weight may be in the range of 0 to 100 percent. In some implementations a sum of the respective weights of the set of performance metrics is 1 or 100 percent.

Weighting the performance metrics may comprise receiving (e.g. retrieving, requesting) the weight value from a memory accessible to the apparatus 102, from user input 410 or combinations thereof.

By way of example, should the set of performance metrics comprise five performance metrics and an operator chooses, due to environmental conditions, such as drought, to emphasize a performance of water consumption of the screening process, he may do so by applying 3/5 or 60 percent of the total weight of the performance metrics to the performance metric indicative of water consumption and a remaining 1/10 or 10 percent to each of the other performance metrics.

The machine performance metric may be seen as a statistical metric (such as an average, a weighted average, a median, a variance, and/or a standard deviation) indicative of a system-level performance of the screening device, such as indicative of a global performance and/or an overall performance and/or an aggregated performance. The machine performance metric is for example indicative of an efficiency of the screening device process, in that the machine performance metric quantifies the efficiency of the screening device process, e.g. in terms of a set of user preferences and/or priorities for power consumption, water consumption, fines contamination, coarse contamination etc. In other words, the machine performance metric may be seen as an efficiency metric providing an overall performance of the screening device in terms of efficiency based on the user preferences and/or priorities.

Alternatively, or in addition, in some implementations the apparatus 102 may be configured to weight the performance metrics automatically, such as to apply one or more weights to the respective performance metrics. For example, in case no input is provided by the user, the apparatus may per default apply equal weight to the respective performance metrics. In such case a determined machine performance metric may represent the equivalence of an averaged performance of the screening device process based on the performance metrics accounted for. In a still further example implementation, the user may select one performance metric deemed prioritized, whereby the apparatus 102 may automatically apply a respective predetermined weight, such as 0 percent, to any other performance metric, thereby effectively not taking the other performance metrics into account.

At S208, a machine performance metric is determined based on the set of performance metrics. The machine performance metric may be determined based on a set of performance metrics according to any embodiments elucidated hereinbefore and may thus be indicative process efficiency in view of the set of performance metrics.

In some embodiments, the machine performance metric is determined based on the normalized and weighted performance metrics, as detailed in the above. The machine performance metric is thereby indicative of a process efficiency of the screening device in view of the performance metrics and the applied weight. Hence in some embodiments, the machine performance metric may be indicative of a performance of the screening process in view of a user's preference or priorities. The method may thereby provide for a machine performance metric that is adaptable to reflect process efficiency in view for example of environmental conditions or economic factors.

At S210, the machine performance metric is compared with machine performance reference data. Machine performance reference data may represent at least one reference value, such as a real value. For example, the reference data may represent a rated efficiency value or a preferred efficiency range of the screening process. Machine performance reference data may be stored in a memory accessible to the apparatus, such as memory 402 or in cloud service(s), and be obtained by the apparatus 102 from at least one of the memory accessible to the apparatus, and user input device 410.

At S212, an indication of a result of the comparison may be provided. The indication may for example indicate whether the machine performance metric fulfils one or more criterion of the machine performance reference data. For example, the indication may indicate that the machine performance metric is within or outside a predetermined range and/or that the machine performance metric should be increased or decreased, for example plus or minus 5 percent respectively.

At S214, an adjustment process for adjusting an operation of the screening device based on the indication of the result is controlled by the apparatus 102 and/or screening device 118. Thereby, the user is assisted in performing the technical task of operating the screening device. In some embodiments, controlling S214 the adjustment process for adjusting an operation of the screening device comprises initiating the adjustment and/or adjusting S214A the operation of the screening device. In some embodiments, controlling S214 the adjustment process for adjusting an operation of the screening device comprises forgoing S214B (such as not triggering, not initiating, and/or not starting) the adjustment process for adjusting an operation. In some embodiments, controlling S214 the adjustment process for adjusting an operation of the screening device comprises forgoing S214C (such as not triggering, not activating, and/or not starting) the initiation of the adjustment process for adjusting an operation of the screening device.

In some embodiments, controlling S214 the adjustment process for adjusting an operation of the screening device comprises displaying S214D one or more user interface objects representative of one or more of: the indication of the result of the comparison, the machine performance metric, and at least one performance metric of the set of performance metrics.

In some embodiments, controlling S214 the adjustment process for adjusting an operation of the screening device comprises communicating S214E a signal indicative of a control of the adjustment process (such as to a sensor and/or an actuator associated with the screening device).

In some embodiments, controlling S214 the adjustment process for adjusting an operation of the screening device comprises controlling one or more screen control parameters. In some embodiments, the one or more screen control parameters includes one or more of: process water spraying parameter, motor speed of an exciter of the screening device, feed speed of the screening device, particle size and/or shape of a feed material being fed to the screening device, stroke shape of the screening device, and stroke angle of the screening device.

At S216, the method 200 may identify (such as determine, predict, and/or generate) future input data for adjusting an operation of the screening device by processing the indication of the result. Processing the indication of the result may comprise providing the indication of the result, e.g. plus 5 percent, as input to a machine learning model, wherein the machine learning model is trained to receive the indication of the result as input and to produce as an output, an indication of the future input data for the adjusting the operation of the screening device. In some embodiments, the apparatus carrying out the method 200 may use the indication of the future input data to adjust the operation of the screening device in a future time period, such as a subsequent time period. In some embodiments, processing the indication of the result may comprise receiving an indication of the identification of the future input data for the adjusting the operation of the screening device as the output of the machine learning model, when the machine learning model is executed in a device external to the apparatus carrying out the method 200.

The future input data may comprise data of any of the types of input data detailed herein, such as screen control parameters, and/or screen process characteristics. By way of example, a future input data may be indicative of a setting of a control parameter for the adjusting the operation of the screening device. The future input data may be seen as predicted input data to be used for adjusting future and/or upcoming operation(s) of the screening device.

The machine learning model may be trained with training data, such as a training dataset. The training data may comprise input data and output data of at least one of the screening device process and a similar screening device process. The training data may represent one or more of historical and real-time data (such as historical and/or real-time input data, historical and/or real-time performance metrics, historical and/or real-time machine performance metrics, historical and/or real-time screen control parameters, historical and/or screen process characteristics, historical and/or real-time process parameters, and historical and/or real-time results of comparison). The training data may be labelled as input data or output data respectively.

The training may be conducted using a semi-supervised learning environment, where some elements of the training data may be manually labelled, and other elements may be unlabelled or labelled through automated tools.

In some embodiments, the machine learning model comprises one or more of: a neural network, decision tree, support vector machine, genetic algorithms, k-means, kernel regression and discriminant analysis and any other tool appropriately configured for the intended purpose outlined herein or combinations thereof.

In some embodiments, the machine learning model is configured to optimize on a performance metric of the screening device by training the machine learning model to solve an optimization problem based on a predetermined set of performance metrics and results. For example, the optimization problem to be solved by the machine learning model may be an optimization problem with discrete variables, such as a discrete optimization, in which future input data is to be generated from a countable set. For example, the optimization problem to be solved by the machine learning model may be an optimization problem with continuous variables such as a continuous optimization, in which an optimal value for e.g. a screen control parameter of the future input data from a continuous function is to be found. For example, the optimization problem to be solved by the machine learning model may include constrained problems (where there exist a constraint on one or more performance metrics) and/or multimodal problems.

At S218, the method may display an indication of the identified future input data. The indication of the identified future input data may be displayed on display 408.

At S220, an operation of the screening device may be adjusted based on the identified future input data.

The adjustment process may further comprise communicating a signal. The signal may comprise control signals for controlling the adjusting of the operation of the screening device. The apparatus 102 may be configured to adjust any of the screen control parameters by communicating such control signals. In an exemplary implementation the apparatus 102 is configured to implement the identified future input data by adjusting screen control parameters in accordance with the identified future input data by communicating control signals. Alternatively, or in addition, the indication of the identified future input data may be displayed on display 408 whereby an operator may trigger the apparatus 102 to issue the control signals via input device 410.

In some embodiments, any one or more of the above actions may be performed continuously or periodically. In some embodiments, any one or more of the above operations S202 - S220 may involve one or more real-time, or near to real-time conditions. Furthermore, it is to be noted that the previously described flow diagrams, unless the description clearly indicates a certain relationship between two or more operations, the described operations may be performed in a different sequence than the one illustrated. For example, two operations shown performed in succession may be performed substantially concurrently, or even in the reverse order. Hence, the illustrated sequence of operations is only indicative of one particular sequence of actions and does not suggest that this is the only possible sequence.

FIG. 3 illustrates an example of an apparatus 102 configured to practice one or more example embodiments. The apparatus 102 may comprise, for example, a server, a controller workstation, a mobile communications device, a vehicle on-board control device, or other kind of appropriately configured data processing device configured to implement functionality described herein. Although the apparatus 102 is illustrated as a single device, it is appreciated that, wherever applicable, functions of the apparatus 102 may be distributed to a plurality of devices.

The apparatus 102 may comprise at least one processor 400. The at least one processor 400 may comprise, for example, one or more of various processing devices or processor circuitry, such as, for example, a co-processor, a microprocessor, a controller, a Digital Signal Processor (DSP), a processing circuitry with or without an accompanying DSP, or various other processing devices including integrated circuits such as, for example, an Application Specific Integrated Circuit (ASIC), a Field Programmable Gate Array (FPGA), a Microcontroller Unit (MCU), a hardware accelerator, a special-purpose computer chip, or the like.

The apparatus 102 may further comprise at least one memory 402. The at least one memory 402 may be configured to store, for example, computer program code or the like, for example, operating system software and application software, and mining vehicle reference performance data and deviation data associated with an operator of a mining vehicle. The at least one memory 402 may comprise one or more volatile memory devices, one or more non-volatile memory devices, and/or a combination thereof. For example, the at least one memory 402 may be embodied as storage devices (such as hard disk drives, solid state drives, magnetic tapes, etc.), optical magnetic storage devices, or semiconductor memories (such as mask ROM, PROM (programmable ROM), EPROM (erasable PROM), flash ROM, RAM (random access memory), etc.).

The apparatus 102 may further comprise a communication interface 406 configured to enable the apparatus 102 to transmit and/or receive information to/from other devices, for example, the cloud system 106. In one example, the apparatus 102 may use the communication interface 406 to transmit or receive signaling information and data in accordance with at least one data communication or cellular communication protocol. The communication interface 406 may be configured to provide at least one wireless radio, such as, for example, a 3GPP mobile broadband connection (e.g., 3G, 4G, 5G, 6G, etc.), or a wired connection.

The apparatus 102 may further comprise a display 408 or an interface to which a display can be connected to. The apparatus 102 may further comprise an input device 410, for example, a keyboard, a mouse etc., for receiving user input.

The apparatus 102 may further comprise a sensor arrangement 412 according to embodiments described hereinbefore.

The apparatus 102 is configured to receive (e.g., via memory 402 and/or interface 406) input data relating to operation of the screening device process.

The apparatus 102 is configured to determine (e.g., via the processor 400), based on the input data, output data indicative of a set of performance metrics of the screening device process.

The apparatus 102 is configured to determine (e.g., via processor 400) based on the output data, a machine performance metric indicative of an efficiency of the screening device process.

The apparatus 102 is configured to compare (e.g., via processor 400) the machine performance metric with machine performance reference data.

The apparatus 102 is configured to provide(e.g., via memory 402 and/or interface 406) an indication of a result of the comparison.

The apparatus 102 is configured to control (e.g., via processor 400) an adjustment process for adjusting an operation of the screening device based on the indication of the result.

The processor 400 is optionally configured to perform any of the operations disclosed in FIG. 2 (such as any one or more of: S202, S204 , S206, S208, S210, S212, S214, S214A, S214B, S214C, S214D, S214E, S216, S218, S220). The operations of the electronic device 300 may be embodied in the form of executable logic routines (e.g., lines of code, software programs, etc.) that are stored on a non-transitory computer readable medium (e.g., the memory 402) and are executed by the processor 400).

Furthermore, the operations of the apparatus 102 may be considered a method that the apparatus 102 is configured to carry out. Also, while the described functions and operations may be implemented in software, such functionality may as well be carried out via dedicated hardware or firmware, or some combination of hardware, firmware and/or software.

The memory 402 may be one or more of a buffer, a flash memory, a hard drive, a removable media, a volatile memory, a non-volatile memory, a random access memory (RAM), or other suitable device. In a typical arrangement, the memory 402 may include a non-volatile memory for long term data storage and a volatile memory that functions as system memory for the processor 400. The memory 402 may exchange data with the processor 400 over a data bus. Control lines and an address bus between the memory 402 and the processor 400 also may be present (not shown in FIG. 3). The memory 402 is considered a non-transitory computer readable medium.

When the apparatus 102 is configured to implement some functionality, some component and/or components of the apparatus 102, for example, the at least one processor 400 and/or the at least one memory 402, may be configured to implement this functionality. Furthermore, when the at least one processor 400 is configured to implement some functionality, this functionality may be implemented using the program code 404 comprised, for example, in the at least one memory 402.

The functionality described herein may be performed, at least in part, by one or more computer program product components such as software components. According to an embodiment, the apparatus may comprise a processor or processor circuitry, for example, a microcontroller, configured by the program code when executed to execute the embodiments of the operations and functionality described herein. The program code 404 is provided as an example of instructions which, when executed by the at least one processor 400, cause performance of apparatus. Alternatively, or in addition, the functionality described herein can be performed, at least in part, by one or more hardware logic components. For example, and without limitation, illustrative types of hardware logic components that can be used include Field-programmable Gate Arrays (FPGAs), Application-Specific Integrated Circuits (ASICs), Application-Specific Standard Products (ASSPs), System-on-a-chip systems (SOCs), Complex Programmable Logic Devices (CPLDs), and Graphics Processing Units (GPUs).

The apparatus 102 may be configured to perform or cause performance of any aspect of the method(s) described herein. Further, a computer program may comprise instructions for causing, when executed, an apparatus to perform any aspect of the method(s) described herein. The computer program may be stored on a computer-readable medium. Further, the apparatus 102 may comprise means for performing any aspect of the method(s) described herein. In one example, the means comprises the at least one processor 400, the at least one memory 402 including the program code 404 (instructions) configured to, when executed by the at least one processor 400, cause the apparatus 102 to perform the method(s). In general, computer program instructions may be executed on means providing generic processing functions. The method(s) may be thus computer-implemented, for example based algorithm(s) executable by the generic processing functions, an example of which is the at least one processor 400. The means may comprise transmission and/or reception means, for example one or more radio transmitters or receivers, which may be coupled or be configured to be coupled to one or more antennas, or transmitter(s) or receiver(s) of a wired communication interface.

The apparatus 102 may be configured to receive information continuously or discontinuously. Receiving information continuously may comprise, for example, receiving a flow of information such as near real-time measurement data. Receiving information discontinuously may comprise, for example, receiving information at set intervals or in response to a performed action.

Generally herein, expressions like "[entity] is configured for....[performing activity]" or "[entity] is configured to...[perform activity]" will include typical cases where a computerized entity (having one or more controllers, processing units, programmable circuitry, etc.) executes software or firmware installed in the computerized entity, wherein the execution occurs in order to perform the activity in question.

Throughout the specification and claims, the following terms take the meanings explicitly associated herein, unless the context clearly dictates otherwise:

The phrase "in one embodiment" as used herein does not necessarily refer to the same embodiment, though it may. Thus, as described below, various embodiments of the disclosure may be readily combined, without departing from the scope or spirit of the disclosure.

As used herein, the term "or" is an inclusive "or operator and is equivalent to the term "and/or," unless the context clearly dictates otherwise.

The term "based on" is not exclusive and allows for being based on additional factors not described unless the context clearly dictates otherwise.

The term "training" herein does not necessarily limit to a supervised, unsupervised or semi-supervised approach. Supervised machine learning is the machine learning task of inferring a function from supervised (labeled) training data. Unsupervised learning is the machine learning task of find hidden structure (function) in unlabeled data. Semi-supervised machine learning includes training with labeled and unlabeled data.

The term "screening process" as used herein may comprise the process of screening material occurring in a screening device.

Any range or device value given herein may be extended or altered without losing the effect sought. Also, any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The steps or operations of the methods described herein may be carried out in any suitable order, or simultaneously where appropriate. Additionally, individual operations may be deleted from any of the methods without departing from the scope of the subject matter described herein. Aspects of any of the embodiments described above may be combined with aspects of any of the other embodiments described to form further embodiments without losing the effect sought.

The term 'comprising' is used herein to mean including the method, blocks, or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from scope of this specification.

## Claims

1. A computer implemented method (200) of monitoring a screening device process efficiency of a screening device (118), the method comprising:
- receiving input data relating to operation of the screening device process (S202);
- based on the input data, determining output data indicative of a set of performance metrics of the screening device process (S204);
- based on the output data, determining a machine performance metric indicative of an efficiency of the screening device process (S208);
- comparing the machine performance metric with machine performance reference data (S210);
- providing an indication of a result of the comparison (S212); and
- controlling an adjustment process for adjusting an operation of the screening device based on the indication of the result (S214).

2. The method according to claim 1, further comprising weighting a respective performance metric of the set of performance metrics (S206).

3. The method according to any one of the preceding claims 1 or 2, further comprising identifying future input data for the adjusting of the operation of the screening device by processing the indication of the result with an electronic processor (S216).

4. The method according to the preceding claim 3, wherein identifying the future input data for the adjusting the operation by processing the indication of the result comprises:
- providing the indication of the result as input to a machine learning model, wherein the machine learning model is trained to receive the indication of the result as input and to produce as an output, an indication of the future input data for the adjusting the operation of the screening device; and
- receiving an indication of the identification of the future input data for the adjusting the operation of the screening device as the output of the machine learning model.

5. The method according to the preceding claim 4, wherein the machine learning model is trained with training data comprising historical input data and historical output data of at least one of the screening device process and a similar screening device process or combinations thereof.

6. The method according to any one of claims 4 or 5, wherein the indication of the future input data is displayed on a display (S218).

7. The method according to the preceding claim 1 to 6, further comprising adjusting the operation of the screening device based on the indication of the result (S220).

8. The method according to any one of the preceding claims 1 to 7, wherein the input data is indicative of a set of process parameters obtained by a sensor arrangement (412) coupled to the screening device, wherein the process parameters are respectively indicative of a process data point of the screening device process.

9. The method according to the preceding claim 8, wherein the sensor arrangement (412) comprises at least one of an optical camera, an RGB camera, an accelerometer, a voltage sensor, a current sensor, a lidar sensor, optical sensor, a depth sensor and a power sensor.

10. The method according to any one of the preceding claims 1 to 9, wherein the input data is indicative of a set of process characteristics respectively indicative of one of a physical property of the screening device and an earth material in the screening device process.

11. The method according to any one of the preceding claims 1 to 10, wherein the input data relates to a set of adjustable screen control parameters of the screening device.

12. The method according to the preceding claim 11, wherein the adjustment process comprises changing a setting of one or more of the adjustable screen control parameters.

13. An apparatus (102) for a screening device (118), the apparatus comprising:
at least one processor (400); and
at least one memory (402) including computer program code (404),
the at least one memory and the computer program code configured to, with the at least one processor, cause the apparatus at least to perform the method according to any one of the preceding claims 1 to 12.

14. A screening device (118) comprising the apparatus (102) according to claim 13.

15. A computer program (404) comprising instructions for causing an apparatus to perform the method according to any one of claims 1 to 12.
